# EUROPÄISCHE PATENTSCHRIFT

(11) **EP 1 907 608 B1**
(45) Veröffentlichungstag und Bekanntmachung des Hinweises auf die Patenterteilung: **19.11.2008**
(21) Anmeldenummer: 06761810.8
(22) Anmeldetag: 16.07.2006
(51) Int. Cl.: C25D 17/10, C25D 17/12

(54) **VERWENDUNG EINER BESCHICHTUNG ZUR ELEKTRISCHEN KONTAKTIERUNG**
USE OF A COATING FOR MAKING ELECTRICAL CONTACT
UTILISATION D'UN REVETEMENT POUR faire un contact ELECTRIQUE

(30) Priorität: 19.07.2005 DE 102005034419
(43) Veröffentlichungstag der Anmeldung: 09.04.2008
(73) Patentinhaber: Rena Sondermaschinen GmbH, 78148 Gütenbach (DE)
(72) Erfinder: HÜBEL, Egon, 90537 Feucht (DE)
(74) Vertreter: Lechner, Armin Anton
(86) Internationale Anmeldenummer: PCT/DE2006/001232
(87) Internationale Veröffentlichungsnummer: WO 2007/009441

(56) Entgegenhaltungen:
- EP-A- 1 172 463
- US-A- 5 785 838
- US-A1- 2004 221 796

## Beschreibung

Die Erfindung betrifft das elektrische Kontaktieren von Gut in elektrolytischen Anlagen. Insbesondere handelt es sich um das elektrolytische Behandeln von Leiterplatten und Leiterfolien in Tauchbadanlagen, horizontalen und vertikalen Durchlaufanlagen und Anlagen mit einem Transport von Rolle zu Rolle. Bei der Behandlung kann es sich um das elektrolytische Ätzen oder Metallisieren handeln. Die wesentliche Verwendung liegt im Bereich der Galvanisierung. Deshalb wird die Erfindung nachfolgend an Beispielen des elektrolytischen Metallisierens beschrieben.
Beim Galvanisieren muß das Gut kathodisch gegen Elektroden, die in diesem Falle Anoden sind, gepolt sein. Zur elektrischen Übertragung dieses Potentiales bzw. des Behandlungsstromes auf das Gut dienen in der Praxis Kontaktklammern, Kontakträder und Kontaktwalzen. Diese müssen mindestens im Bereich des zu kontaktierenden Gutes auch an der Oberfläche bzw. an den Kontaktflächen elektrisch leitfähig sein. Dies hat zur Folge, dass diese Bereiche ebenso wie das Gut metallisiert werden. Diese Metallisierung ist störend und sie muß kontinuierlich oder von Zeit zu Zeit von den Kontakten entfernt werden. Diese Entmetallisierung erfolgt in der Praxis der Leiterplattentechnik bei Kupferbädem bevorzugt elektrolytisch. Hierzu werden im Elektrolyten die Kontaktmittel zeitweise oder permanent anodisch gegen eine kathodische Hilfselektrode geschaltet. Damit sich dabei der Kontaktwerkstoff nicht anodisch auflöst, muß dieser im Elektrolyten anodisch, d.h. elektrochemisch resistent sein. Hierzu eignen sich z.B. die Werkstoffe Titan, Niob oder Tantal. Diese Metalle bilden im Elektrolyten sehr schnell eine unvermeidliche Oxidschicht, die einen anodischen Abtrag verhindert, weil sie ein elektrischer Isolator ist. Dies ist jedoch für ein Kontaktmittel sehr nachteilig. Nur durch eine ausreichend hohe Kontaktkraft von z.B. 30 N und reibende Bewegung beim Schließen oder Abrollen des Kontaktes wird die dünne und poröse Oxidschicht zur Stromführung durchbrochen. Dies ist in der Praxis sehr unzuverlässig und es verursacht einen erhöhten Verschleiß der Kontaktmittel. Gleichzeitig werden die Kontakte durch die poröse Oxidschicht und/oder durch die durchbrochene Oxidschicht ebenso wie das Gut metallisiert. Dabei wächst diese sehr störende Metallisierung auch über die isolierenden Oxidschichten hinweg.
Bei einer elektrolytischen Entmetallisierung der Kontaktmittel wird versucht, mit einer möglichst hohen Zellspannung zu arbeiten, um die Metallisierung wieder vollständig zu entfernen. Dies hat zwei wesentliche Nachteile. Zum einen beginnen sich bei einem hohen anodischen Potential auch die im unteren Spannungsbereich resistenten Metalle anodisch aufzulösen. Bei Titan liegt diese Grenze der beginnenden Auflösung in sauren Kupferbädem bei ca. 10 Volt. Zum anderen verlieren diese störenden Metallisierungen der Kontaktmittel den elektrischen Kontakt zum Kontaktkörper, weil mit zunehmender Metallisierung auch der dafür wirksame Behandlungsstrom zunimmt. Die wenigen und im Querschnitt sehr kleinen elektrischen Verbindungen durch die Oxidschicht hindurch zum Kontaktkörper werden durch den hohen Strom beim Entmetallisieren wie bei einer Sicherung unterbrochen. Beim anschließenden Metallisieren werden sie wieder geschlossen.
Ein hoher Entmetallisierungsstrom ist jedoch erforderlich, um die Metallisierung der Kontaktmittel wenigstens aufzuhalten. Das erforderliche Gleichgewicht zwischen Metallisierung und Entmetallisierung ist bei der Leiterplattenproduktion nur für eine kurze Zeit einzuhalten. Im Anschluss daran äußert sich das gestörte Gleichgewicht durch eine massive Metallisierung der aus elektrisch nicht leitenden, oxidierenden metallischen Werkstoffen bestehenden Kontaktmittel. Bereits nach wenigen Produktionsstunden kann es bei der Leiterplattenbehandlung in Abhängigkeit von der Höhe der angewandten Stromdichten für die Metallisierung und Entmetallisierung zu einer bleibenden Verkupferung der Kontaktmittel führen, die außerhalb der Anlage wieder entfernt werden muß.
Deshalb wird in der Praxis versucht, die oxidierenden Oberflächen der Kontaktmittel mit einer Edelmetallbeschichtung zu schützen. Hierzu verwendet man z.B. eine elektrolytische Gold- oder Platinbeschichtung mit einer Dicke von z.B. 5 µm. Damit sind die Kontakt gebenden Flächen frei von elektrisch isolierenden Oxiden und elektrisch gut kontaktierend. Es zeigt sich jedoch, dass die Haftfestigkeit von elektrolytischen Beschichtungen auf den isolierenden oxidierenden Metallen gering ist. Hinzu kommt, dass die Leiterplatten an ihren Schnittkanten in Folge der Verstärkung mittels Glasfasern sehr scharfkantig sind. Kontakträder rollen in Durchlaufanlagen auf jede Leiterplattenkante auf. Insgesamt führt dies in der Praxis dazu, dass die weichen metallischen Beschichtungen schon nach wenigen Tagen oder Wochen in der Produktion vom Kontaktkörper abgerieben und damit entfernt worden sind.
Der Übergang zum unbeschichteten Kontaktkörper mit den oben beschriebenen Problemen erfolgt zeitlich schleichend. Entsprechend nimmt die unerwünschte Metallisierung des Kontaktes wieder zu. Die elektrolytische Behandlung der Leiterplatten erfolgt dadurch nur mangelhaft. Ein Austausch der verbrauchten Kontaktmittel gegen neue mit Edelmetall beschichtete ist in der Regel sehr zeitaufwendig und mit hohen Kosten, insbesondere auch für Beschichtung selbst verbunden.

In der Druckschrift DE 198 40 471 A1 wird eine derartige Kontakteinrichtung zur elektrolytischen Leiterplattenbehandlung beschrieben. Kontaktierräder 19 sind an den Kontakt gebenden Flächen mit Segmenten 20 versehen. Die Segmente 20 bestehen aus Titan. Zur Vermeidung eines teuren Platinüberzuges und zum Schutz des Titans vor Auflösung wird vorgeschlagen, mit Überwachungs- und Steuermitteln die elektrolytische Entmetallisierung der Segmente 20 zu kontrollieren. Der Verlauf einer Spannungs-Stromkurve der Entmetallisierungszelle soll Aufschluß über den Grad der Entmetallisierung geben. Zur vorbestimmten Situation wird die elektrische Entmetallisierung deaktiviert.

Eine horizontale Durchlaufanlage für Leiterplatten besteht aus sehr vielen derartigen rotierenden Kontakträdern 19. Zum Beispiel aus 60 Stück. Entsprechend sehr groß ist der vorgeschlagene technische Aufwand, der zur Steuerung der elektrolytischen Entmetallisierung der Kontakte aufzubringen ist.
In der Druckschrift 36 45 319 C2 werden Klammern oder Bügel 17, 18 beschrieben, die an ihren unteren Enden 21, 22 das Gut, insbesondere plattenförmige Gegenstände 2 erfassen und elektrisch kontaktieren. Dabei werden mindestens auch die unteren Enden metallisiert. Diese störende Metallisierung soll in einer nachgeordneten Entmetallisierungseinrichtung elektrolytisch wieder entfernt werden. Auch bei dieser Erfindung treten die oben beschriebenen Probleme auf. Die Oxidschicht des elektrolytisch resistenten Werkstoffes der Kontaktmittel stört bei der Kontaktierung und bei der Entmetallisierung.
Die Druckschrift DE 196 33 797 A1 beschreibt drehbar angeordnete Kontakt- und Transportmittel einer Durchlaufanlage zur elektrolytischen Behandlung von Leiterplatten. Diese Mittel weisen zumindest bereichsweise auf ihrer Mantelfläche eine metallische Beschichtung auf. Mittels einer Hilfselektrolyse wird die unerwünschte Metallisierung der Kontaktmittel auf Entkupferungskathoden abgeschieden. Auch bei dieser Erfindung treten im Bereich der elektrischen Kontaktierung des Gutes die beschriebenen Nachteile auf. Gleiches gilt für rotierende oder schleifende Kontaktbürsten aus Metallfasern, Metallgeweben oder elektrisch leitfähigen Kunststofffasern.

In der Praxis ist nach dem Stand der Technik immer ein Kompromiß zwischen Metallisierung, Entmetallisierung und Standzeit der Kontaktmittel zu suchen. Die grundsätzlich möglichen Edelmetallbeschichtungen sind wirtschaftlich nicht vertretbar, weil sie zu weich und daher nicht ausreichend abriebfest sind.

Aufgabe der Erfindung ist es, eine Vorrichtung zur elektrischen Kontaktierung von Gut in elektrolytischen Tauchbadanlagen, horizontalen und vertikalen Durchlaufanlagen und Anlagen mit einem Transport von Rolle zu Rolle zu beschreiben, die obige Nachteile nicht aufweist und die kostengünstig und technisch einfach zu realisieren ist. Die Oberflächen der Kontakt gebenden Konstruktionselemente als z.B. segmentierte Kontaktierräder, Kontakträder, Kontaktbürsten oder Klammern sollen nicht oxidierend und elektrisch leitfähig sein. Des weiteren sollen sie abriebfest und gegen einen vorzeitigen Verschleiß geschützt sein.

Eine weitere Aufgabe ist es, eine Verwendung für eine Beschichtung anzugeben, welche für eine wie vorstehend beschriebene Kontaktierung geeignet ist.

Gelöst wird die Aufgabe durch die Verwendung einer Beschichtung auf einem Kontaktmittel gemäß Patentanspruch 1 und durch eine Vorrichtung gemäß Patentanspruch 2. Vorteilhafte Weiterbildungen sind in den Unteransprüchen beschrieben.

Erfindungsgemäß wird mindestens partiell die Oberfläche der Kontaktmittel, die aus einem oxidierenden und chemisch beständigen Metall bestehen, mit einer Diamantbeschichtung versehen, die durch entsprechende Dotierung elektrisch leitfähig ist. Diese Beschichtung ist chemisch und elektrochemisch resistent, mechanisch sehr stabil und abriebfest und sie weist eine Temperaturbeständigkeit von bis zu 600°C auf.
Leitfähige Diamantschichten für Elektroden werden u.a. in der Druckschrift M.Fryda, "*Eigenschaften und Anwendungen von Diamantelektroden*" JOT, 1999/5 VI - IX beschrieben. In einem CVD-Verfahren (chemical vapour deposition) wird durch Dotierung mit Bor eine elektrisch leitfähige Schicht auf dem Grundwerkstoff hergestellt.
Überraschend zeigte sich, dass zur Beschichtung der Kontaktmittel nur eine sehr dünne Schicht von ca. 2 µm bis 5 µm benötigt wird. Deshalb ist auch die spezifische elektrische Leitfähigkeit für diese Anwendung vollkommen ausreichend. Sie kann bis zu 100 (Ωcm)⁻¹ erreichen, was nahe an die von Metallen heranreicht.

Auch die weiteren Eigenschaften der elektrisch leitfähigen Diamantbeschichtung eignen sich hervorragend für Kontaktmittel bei elektrolytischen Prozessen:
- Chemische und elektrochemische Resistenz.
   Dadurch erfolgt auch bei anodischer Polarität keine Oxidation und praktisch kein Schichtabtrag. Die Zellspannung der Entmetallisierungszelle kann daher hoch gewählt werden, z.B. 12 V und mehr, ohne die Beschichtung und/oder den durch die Beschichtung geschützten Grundkörper des Kontaktes anodisch aufzulösen. Weil die Oberflächen der beschichteten Kontakte nicht oxidieren, erfolgt die Metallisierung gleichmäßig auf der gesamten Oberfläche. Gleiches geschieht bei der anschließenden Entmetallisierung. Ein Abriß der elektrischen Verbindung von der zu entfernenden Metallisierung zum Grundkörper findet wegen der großflächigen Kontaktierung nicht statt.
- Sehr hohe mechanische Verschleißfestigkeit.
   Dies sorgt für eine große Beständigkeit auch bei der Produktion von scharfkantigen und mit Glasfasern verstärkten Leiterplatten.
Mit dieser mindestens an der Kontakt gebenden Oberfläche versehenen Beschichtung der Kontaktmittel werden alle beschriebenen Nachteile der Kontaktmittel nach dem Stand der Technik beseitigt. Bei Verwendung der Diamantbeschichtung, besonders für Klammern, erweist sich die Temperaturbeständigkeit von bis zu 600°C als ein weiterer Vorteil. Die Klammern werden partiell nur an den Kontakt gebenden Stellen mit der elektrisch leitfähigen Diamantbeschichtung versehen. Anschließend können sie mit einer isolierenden Kunststoffbeschichtung im übrigen Bereich überzogen werden, z.B. mit Halar. Dieser Bereich ist in der elektrolytischen Zelle dem elektrischen Feld ausgesetzt. Die Kunststoffbeschichtung verhindert eine Metallisierung. Die Herstellung der Beschichtung erfolgt z.B. bei einer Temperatur von 500°C. Die zuvor aufgebrachte Diamantbeschichtung wird dadurch nicht beschädigt.
Eine partielle Edelmetallbeschichtung der Enden der Klammern nach dem Stand der Technik könnte wegen der hohen Arbeitstemperatur bei der weiteren Kunststoffbeschichtung nicht aufgebracht werden. Die Edelmetalleschichtung wird bei diesen Temperaturen beschädigt, insbesondere ihre Haftfestigkeit auf den oxidierenden Metallen geht verloren.
Wegen der großen mechanischen Abmessungen von bis zu 0,4 m für die Klammern können auch austauschbare Klemmbacken am unteren Ende der Klammern verwendet werden. Die Klemmbacken sind dann Kleinteile, die kostengünstig mit der elektrisch leitfähigen Diamantbeschichtung beschichtet werden können. Diese werden nach der Beschichtung z.B. mittels Schrauben an der isolierten Klammer befestigt. Damit sind sie auch jederzeit austauschbar.

## Patentansprüche

1. Verwendung einer elektrisch leitfähigen Diamantbeschichtung zur Oberflächenbehandlung als Schutzschicht auf elektrische Kontaktmitteln, die aus einem chemisch und elektrochemisch resistenten Metall mit einer bei anodischer Polarität elektrisch isolierenden Oxidschicht bestehen und die zur Behandlungsstromübertragung auf zu beschichtendes Gut in elektrolytischen Anlagen dienen.

2. Vorrichtung zur Behandlungsstromübertragung auf ein zu beschichtendes Gut in elektrolytischen Anlagen, **gekennzeichnet durch** ein Kontaktmittel aus einem chemisch und elektrochemisch resistenten Metall mit einer bei anodischer Polarität elektrisch isolierenden Oxidschicht, wobei das Kontaktmittel an einer ersten Oberfläche, welche vorgesehen ist, mit dem zu beschichtenden Gut in Kontakt zu kommen, mit einer elektrisch leitfähigen Diamantbeschichtung beschichtet ist.

3. Vorrichtung nach Anspruch 2, **gekennzeichnet durch** elektrisch isolierende Beschichtungen an einer zweiten Oberfläche des Kontaktmittels, wobei die zweite Oberfläche nicht vorgesehen ist, mit dem zu beschichtenden Gut in Kontakt zu kommen, und wobei die zweite Oberfläche einem elektrischen Feld in einer elektrolytischen Zelle der elektrolytischen Anlage ausgesetzt ist.

4. Vorrichtung nach einem der Ansprüche 2 oder 3, **gekennzeichnet durch** austauschbare Klemmbacken als Kontaktmittel, die mit der Diamantbeschichtung beschichtet sind und **durch** Halter oder Klemmen, die mit einer elektrisch isolierenden Beschichtung versehen sind.

5. Vorrichtung nach einem der Ansprüche 2 bis 4, **gekennzeichnet durch** Kontaktmittel, welche als segmentierte Kontaktierräder, Kontakträder, Kontaktbürsten oder Klammern ausgebildet sind.

## Claims

1. Use of an electrically conductive diamond coating for surface treatment as a protective coating on electrical contact means consisting of a chemically and electrochemically resistant metal with an oxide layer electrically isolating at anodic polarity and serving for treatment current transfer to matter to be coated in electrolytic plants.

2. Apparatus for treatment current transfer to matter to be coated in electrolytic plants, **characterized by** a contact means of a chemically and electrochemically resistant metal with an oxide layer electrically isolating at anodic polarity, wherein the contact means is coated with an electrically conductive diamond coating on a first surface intended to come into contact with the matter to be coated.

3. Apparatus according to claim 2, **characterized by** electrically isolating coatings on a second surface of the contact means, wherein the second surface is not intended to come into contact with the matter to be coated, and wherein the second surface is exposed to an electrical field in an electrolytic cell of the electrolytic plant.

4. Apparatus according to any one of claims 2 or 3, **characterized by** exchangeable jaws as contact means coated with the diamond coating, and by brackets or clips provided with an electrically isolating coating.

5. Apparatus according to any one of claims 2 to 4, **characterized by** contact means formed as segmented contacting wheels, contact wheels, contact brushes or clamps.

## Revendications

1. Utilisation d'un revêtement en diamant électriquement conducteur pour le traitement de surface, à titre de couche protectrice sur des moyens de contact électriques, qui se composent d'un métal chimiquement et électrochimiquement résistant, avec une couche d'oxyde électriquement isolante, en présence d'une polarité anodique et qui servent au transfert de courant aux fins de traitement sur un produit à revêtir dans des installations électrolytiques.

2. Appareil destiné au transfert de courant aux fins de traitement sur un produit à revêtir dans des installations électrolytiques, **caractérisé par** un moyen de contact dans un métal chimiquement et électrochimiquement résistant, avec une couche d'oxyde électriquement isolante, en présence d'une polarité anodique, le moyen de contact étant revêtu sur une première surface, qui est prévue pour venir en contact avec le produit à revêtir, avec un revêtement en diamant électriquement conducteur.

3. Appareil suivant la revendication 2, **caractérisé par** des revêtements électriquement isolants sur une deuxième surface du moyen de contact, la seconde surface n'étant pas prévue pour venir en contact avec le produit à revêtir et la seconde surface étant exposée à un champ électrique dans une cellule électrolytique de l'installation électrolytique.

4. Appareil suivant l'une des revendications 2 ou 3, **caractérisé par** des mâchoires de serrage échangeables en tant que moyens de contact, qui sont revêtues avec le revêtement en diamant et par des supports ou des pinces, qui sont munies d'un revêtement électriquement isolant.

5. Appareil suivant l'une des revendications 2 à 4, **caractérisé par** des moyens de contact, lesquels sont formés en tant que roues segmentées de mise en contact, roues de contact, balais de contact ou brides.
